(19) Europäisches Patentamt / European Patent Office / Office européen des brevets

(11) **EP 1 708 323 B1**

(12) **EUROPEAN PATENT SPECIFICATION**

(45) Date of publication and mention
of the grant of the patent:
**06.01.2010 Bulletin 2010/01**

(51) Int Cl.:
*H01S 5/14* (2006.01)   *H01S 5/10* (2006.01)
*H01S 5/06* (2006.01)   *H01S 5/02* (2006.01)
*H01S 5/0687* (2006.01)   *G02B 6/12* (2006.01)
*H04B 10/155* (2006.01)

(21) Application number: **06006412.8**

(22) Date of filing: **28.03.2006**

(54) **Tunable laser with multiple ring resonator and mode filter**

Abstimmbarer Laser mit Mehrfachringresonator und Modenfilter

Laser accordable avec multiples résonateurs en anneau et avec filtre de mode

(84) Designated Contracting States:
**DE FR GB IT NL SE**

(30) Priority: **29.03.2005 JP 2005096224**

(43) Date of publication of application:
**04.10.2006 Bulletin 2006/40**

(73) Proprietor: **NEC CORPORATION**
**Minato-ku,**
**Tokyo 108-8001 (JP)**

(72) Inventor: **Yamazaki, Hiroyuki**
**NEC Corporation**
**Tokyo, 108-8001 (JP)**

(74) Representative: **Vossius & Partner**
**Siebertstrasse 4**
**81675 München (DE)**

(56) References cited:
**EP-A- 1 391 972    WO-A-2004/034528**

- TAKAHASHI M ET AL: "A stable widely tunable laser using a silica-waveguide triple-ring resonator" 2005 OPTICAL FIBER COMMUNICATIONS CONFERENCE, ANANHEIM, CA, USA, 6-11 MARCH 2005 POST DEADLINE PAPERS (IEEE CAT. NO. 05CH37672), vol. 5, 11 March 2005 (2005-03-11), pages PDP19.1-PDP19.3, XP002382864 ISBN: 1-55752-783-0
- SHIMODA T. ET AL: "Low-Loss, Polarization-Independent Silicon-Oxynitride Waveguides for High-Density Integrated Planar Lightwave Circuits" PROCEEDINGS OF THE EUROPEAN CONFERENCE ON OPTICAL COMMUNICATIONS (ECOC) 2002 , PLANAR LIGHTWAVE CIRCUITS II, PAPER TH4.2.4, 2002, pages 1-2, XP002383064
- BENTE E A J M ET AL: "WAVELENGTH SELECTION IN AN INTEGRATED MULTIWAVELENGTH RING LASER" IEEE JOURNAL OF QUANTUM ELECTRONICS, IEEE SERVICE CENTER, PISCATAWAY, NJ, US, vol. 40, no. 9, September 2004 (2004-09), pages 1208-1216, XP001214171 ISSN: 0018-9197
- YAMAZAKI H. ET AL: "Widely Tunable Laser Consisting of a Silica Waveguide Double Ring Resonator Connected Directly to a Semiconductor Optical Amplifier" PROCEEDINGS OF THE EUROPEAN CONFERENCE ON OPTICAL COMMUNICATIONS (ECOC) 2004 , POSTDEADLINE PAPER TH4.2.4, 2004, pages 22-23, XP009066926
- BIN LIU ET AL: "Wide Tunable Double Ring Resonator Coupled Lasers" IEEE PHOTONICS TECHNOLOGY LETTERS, IEEE SERVICE CENTER, PISCATAWAY, NJ, US, vol. 14, no. 5, May 2002 (2002-05), XP011067104 ISSN: 1041-1135

## Description

The present invention relates to a tunable laser which can vary the oscillation wavelength thereof.

As broadband communications are becoming more and more popular, attempts are being made to introduce WDM (Wavelength Division Multiplexing) transmission systems that are capable of communications at a plurality of different optical wavelengths over a single optical fiber for efficient utilization of fiber optic transmission paths. Recently, DWDM (Dense WSD) apparatus for multiplexing optical signals of several tens of wavelengths for higher-rate transmission have also been finding growing use. Efforts have also been made to commercialize ROADM (Reconfigurable Optical Add/Drop Multiplexers) for adding and dropping optical signals of desired wavelengths at each node in the optical networks. If ROADM systems are introduced into the communication environment, then the flexibility of optical networks will dramatically be increased because they are capable of optical path switching by changing wavelengths as well as the transmission capacity is increased by wavelength multiplexing.

The WDM transmission system requires as many light sources as the number of wavelengths that are employed. Therefore, as the number of wavelengths to be multiplexed by the WDM transmission system increases, the number of light sources that are required also increases.

DFB-LDs (Distributed Feedback Laser Diodes) which oscillate in a single axial mode have widely been used as light sources in WDM transmission systems for the ease and reliability with which they can be used. The DFB-LD has a diffraction grating having a depth of about 30 nm which is disposed entirely in the resonator. The DFB-LD oscillates stably in the single axial mode at a wavelength corresponding to the product of the period of the diffraction grating and a value that is twice the equivalent refractive index. However, since it is impossible to tune the DFB-LD for a wide range of oscillation wavelengths, a DFB-LD-based WDM transmission system employs DFB-LD devices having different wavelengths for respective ITU (International Telecommunication Union) grids. The need for using DFB-LD devices having different wavelengths makes the DFB-LD-based WDM transmission system problematic because the shelf control cost is high and a redundant inventory of DFB-LDs is required in preparation for DFB-LD failures. If the ROADM system that is capable of optical path switching by changing wavelengths employs ordinary DFB-LDs, then the variable extent of the wavelength range is limited to about 3 nm that can be changed with a temperature change, making it difficult to construct an optical network incorporating the features of the ROADM that positively uses wavelength resources.

Intensive research has been conducted on tunable lasers in order to solve the problems of the present DFB-LDs and achieve single-axial-mode oscillation in a wide range of wavelengths. One example of such research efforts is shown in "*Hikari Syuseki Devices* (Optical integrated devices)", written by Isao Kobayashi, first edition, second printing, Kyoritsu Shuppan Co., Ltd., December 2000, pages 104 - 122. Some examples described in this literature will be given below to describe conventional tunable lasers.

Tunable lasers are generally classified into two types, i.e., tunable lasers with a wavelength varying mechanism disposed in a laser element and tunable lasers with a wavelength varying mechanism disposed outside of a laser element.

One proposed tunable laser with a wavelength varying mechanism disposed in a laser element is a DBR-LD (Distributed Bragg Reflector Laser Diode) having an active region for producing a gain and a DBR region for producing a reflection with a diffraction grating, the active region and the DBR region being disposed in one laser element. The DBR-LD has a variable wavelength range of about 10 nm at maximum. There has also been proposed a DBR-LD employing a nonuniform diffraction grating which has an active region for producing a gain and front and rear DBR regions sandwiching the active region. The active region and the DBR regions are disposed in one laser element. In the front and rear DBR regions, the nonuniform diffraction grating produces a number of reflection peaks spaced at intervals that are slightly different in the front and rear DBR regions. Since this structure causes a vernier effect, the DBR-LD with the nonuniform diffraction grating makes it possible to change wavelengths in a very wide range, and can achieve wavelength varying operation in a range in excess of 100 nm and can achieve quasi-continuous wavelength varying operation in a range of 40 nm.

One proposed tunable laser with a wavelength varying mechanism disposed outside of a laser element is a tunable laser having a diffraction grating disposed outside of a laser element, the diffraction grating being rotatable to return light at a particular wavelength to the laser element. The tunable laser of this type requires a mechanism for sequentially monitoring oscillating wavelengths. Heretofore, a wavelength-selective component such as an etalon or the like is incorporated in the module for monitoring oscillating wavelengths.

Though many structures have been proposed for use as conventional tunable lasers, it has been difficult to put them to practical use because of various problems including mode hopping, complex wavelength control, weak vibration resistance, and high cost due to device enlargement.

The DBR-LD changes wavelengths by injecting carries into the DBR region to change the refractive index thereof. If crystal defects grow on account of the electric current injection, then the ratio of a refractive index change to the electric current injection changes greatly, making it difficult to maintain laser oscillation at a constant wavelength over a long period of time. Since the DBR-LD is of a complex structure, it tends to have a large size.

According to the present compound semiconductor device fabrication process technology, it is impossible to increase the size of a laser substrate by 2 inches (50.8 mm) or more. Consequently, it is difficult to reduce the present price of DBR-LDs.

The tunable lasers with the wavelength varying mechanism disposed in the laser element are liable to bring about mode jumping due to vibration. These tunable lasers need a large vibration-resistant mechanism and tend to have a large module size and an increased cost. The tunable lasers also suffer an increased assembling cost as they require many optical components such as a photodetector in addition to the etalon for monitoring oscillating wavelengths. It has been customary to spatially couple the laser emitting surface and the etalon to each other with a lens for wavelength monitoring. According to the customary approach, a slight positional error of the etalon is apt to vary the accuracy of wavelengths. Therefore, the highly accurate mounting technology is required to install the etalon in position. However, the highly accurate mounting technology is also responsible for an increase in the assembling cost of tunable lasers.

The following documents relate to ring laser:

TAKAHASHI M ET AL: "A stable widely tunable laser using a silica-waveguide triple-ring resonator" 2005 OPTICAL FIBER COMMUNICATIONS CONFERENCE, ANAHEIM, CA, USA, 6-11 MARCH 2005 POST DEADLINE PAPERS, vol. 5,11 March 2005, pages PDP19.1-PDP19.3;
WO 2004/034528 A (LAMBDA CROSSING LTD; MARGALIT, MOTI; YASIN, MICHAEL; ORENSTEIN, MEIR) 22 April 2004;
BENTE E A J M ET AL: "WAVELENGTH SELECTION IN AN INTEGRATED MULTIWAVELENGTH RING LASER" IEEE JOURNAL OF QUANTUM ELECTRONICS, vol. 40, no. 9, September 2004, pages 1208-1216.

It is an object of the present invention to provide a tunable laser which will solve the problems of the conventional tunable lasers, is highly reliable, is of high performance and low cost, and has a simple arrangement for monitoring wavelengths.

The above object is achieved by a tunable laser according to the claims, i.a., having a multiple ring resonator comprising a plurality of ring resonators having respective ring-shaped waveguides and respective different optical path lengths, a first optical waveguide coupled to the multiple ring resonator, an optical input/output device coupled to the first optical waveguide, a second optical waveguide coupled to the multiple ring resonator, an optical reflector coupled to the second optical waveguide, a wavelength varying mechanism for changing the resonant wavelength of the multiple ring resonator, and a filter for preventing light in high-order modes from being introduced into the multiple ring resonator and for propagating light in a fundamental mode in the multiple ring resonator.

In this tunable laser, light emitted from the optical input/output device is introduced into the first optical waveguide, and then travels successively through the multiple ring resonator, and the second optical waveguide to the optical reflector, and then travels back successively through the second optical waveguide and the multiple ring resonator and is applied as returning light from the first optical waveguide to the optical input/output device. Since the filter is disposed somewhere in the above optical path, the returning light applied from the first optical waveguide to the optical input/output device is light in the fundamental mode. The returning light becomes most intensive at the resonant wavelength of the multiple ring resonator because since the ring resonators of the multiple ring resonator have slightly different FSRs (Free Spectral Ranges), a greater reflection occurs at a wavelength (i.e., resonant wavelength) where periodic changes of reflections (transmissions) occurring in the respective ring resonators coincide with each other. The first optical waveguide is also referred to as an input/output side waveguide because the first optical waveguide is disposed between the multiple ring resonator and the optical input/output device, and the second optical waveguide is also referred to as a reflection side waveguide because the second optical waveguide is disposed between the multiple ring resonator and the optical reflector.

With this arrangement, light that passes through the through port of a ring resonator is minimum at the resonant wavelength of the multiple ring resonator. If an optical coupler for optically coupling the ring resonators is disposed in the multiple ring resonator, then the resonant wavelength of the multiple ring resonator can be detected by detecting the amount of light at the through port of the optical coupler.

The wavelength at which the periodic changes coincide with each other changes greatly depending on the circumferential lengths of the ring resonators and a change in the waveguide refractive index. Therefore, the tunable laser can operate efficiently to change the oscillation wavelength by changing the waveguide refractive index. The waveguide refractive index can be changed according to the thermo optical effect, for example. The thermooptical effect refers to a phenomenon in which the refractive index of a material increases as the temperature thereof increases. Any general materials exhibit the thermooptical effect to respective different extents. According to the present invention, the resonant wavelength of the multiple ring resonator can be changed based on the temperature characteristics of the ring resonators. The wavelength varying mechanism may heat or cool a ring resonator partly or wholly for changing the waveguide refractive index of the ring resonator. The wavelength varying mechanism may preferably comprise a film heater for heating the ring-shaped waveguide of the ring resonator.

According to the present invention, ring resonators whose circumferential lengths are slightly different from each other are coupled in series to each other, providing the multiple ring resonator, and the vernier effect provided by the multiple ring resonator is utilized to greatly change the resonant wavelength of the multiple ring resonator as a whole by changing the resonant wavelengths of the ring resonators.

Structural and operational details of the filter provided in the tunable laser according to the present invention will be described below.

For the tunable laser to achieve high-output characteristics required by the user, it is necessary that a loss caused by each of the ring resonators be reduced maximally. According to the present invention, the filter is effective to prevent the light in the high-order modes from circulating through the ring resonators. Stated otherwise, the light in the high-order modes is prevented from circulating through the ring resonators in order to achieve good wavelength characteristics in the ring resonators. The introduction of a mode filter is effective to prevent the light in the high-order modes from being introduced into the multiple ring resonator and to propagate only the light in the fundamental mode in the multiple ring resonator. The mode filter may comprise a constricted waveguide having a constricted portion or a bent waveguide having a certain radius of curvature. Alternatively, the mode filter may comprise an S-shaped waveguide made up of a combination of two bent waveguides. The mode filter increases the mode selectivity of the tunable laser, allowing the tunable laser to oscillate stably in a single axial mode. According to the present invention, therefore, the multiple ring resonator and the filter which are combined with each other make it possible for the tunable laser to operate for good wavelength selection and also to oscillate stably in a single axial mode over a long period of time.

The tunable laser according to the present invention may further includes a substrate on which the multiple ring resonator, the first optical waveguide, and the second optical waveguide may be disposed. The substrate comprises a PLC (Planar Lightwave Circuit) substrate, for example. As described above, the wavelength varying mechanism serves to change the resonant wavelength of the multiple ring resonator based on the temperature characteristics of each of the ring resonators, and specifically, the wavelength varying mechanism may comprise a film heater disposed on the substrate. As the film heater can easily be provided by depositing a metal film, for example, on the substrate, the film heater can easily be manufactured. The optical reflector may preferably be a highly reflecting film disposed on an end face of the substrate.

The optical input/output device may comprise a laser diode (hereinafter referred to as LD), a semiconductor optical amplifier (hereinafter referred to as SOA), an optical fiber amplifier, or the like.

The tunable laser according to the present invention may further comprise a photodetector for detecting light propagated through the multiple ring resonator, and a control circuit for controlling the wavelength varying mechanism based on the light detected by the photodetector. The photodetector may comprise a semiconductor photodetector such as a photodiode, a phototransistor, or the like, and detect light at the through port of either one of the ring resonators. The control circuit comprises a circuit for performing feedback control through the wavelength varying mechanism so that the resonant wavelength of light which is propagated through the multiple ring resonator will be constant.

According to the present invention, though the tunable laser is of a simple structure for changing the resonant wavelength of the multiple ring resonator, it can achieve a large wavelength change based on a small operating action, and the multiple ring resonator and the filter are combined with each other, making it possible for the tunable laser to operate for good wavelength selection and also to oscillate stably in a single axial mode over a long period of time. The tunable laser according to the present invention is more inexpensive, is of higher performance, and is more reliable than conventional tunable lasers. With the optical input/output device being disposed on the substrate on which the multiple ring resonator is mounted, the tunable laser can produce a laser beam in a very wide wavelength range by changing the resonant wavelength of the multiple ring resonator.

Since the tunable laser according to the present invention can change the oscillating wavelength without the need for the injection of an electric current injected into a semiconductor laser and also without the need for movable components, the tunable laser is highly reliable in operation. Specifically, since the tunable laser is of a simple arrangement in which the optical input/output device is mounted on the substrate on which the multiple ring resonator, the optical reflector, and the first and second optical waveguides are disposed, the tunable laser can be manufactured easily and inexpensively. The tunable laser according to the present invention does not require optical components such as an etalon or the like, can easily be assembled, and has a low module cost, but still has functions required by a transmission system in which the tunable laser is to be incorporated.

Stated otherwise, the tunable laser according to the present invention is of a simple structure free of an external mirror and is capable of changing wavelengths in a wider range than the ordinary DFB-LDs can change wavelengths. Furthermore, since the tunable laser has no movable components unlike ordinary external-mirror tunable lasers, the tunable laser is highly reliable in operation and is highly resistant to vibrations and shocks. As the tunable laser can be tuned for wavelengths by controlling the electric power supplied to the film heater, for example, any characteristic aging of the tunable laser is much smaller than tunable lasers which change wavelengths by injecting an electric current into a semiconductor waveguide.

As described above, the tunable laser according to the present invention is much more excellent than conventional tunable lasers, and is highly practically useful because it can be manufactured at a low cost.

The above and other objects, features, and advantages of the present invention will become apparent from the following description with reference to the accompanying drawings which illustrate examples of the present invention.

FIG. 1 is a plan view of a tunable laser according to a first embodiment of the present invention;
FIGS. 2A, 2B, and 2C are plan views of mode filters according to first, second, and third examples, respectively, for use in the tunable shown in FIG. 1;
FIG. 3 is a plan view of a tunable laser according to a second embodiment of the present invention;
FIG. 4 is a diagram illustrating the operating principles of the tunable laser shown in FIG. 3; and
FIG. 5 is a plan view of a modified tunable laser which comprises the tunable laser shown in FIG. 3 and a control circuit added thereto.

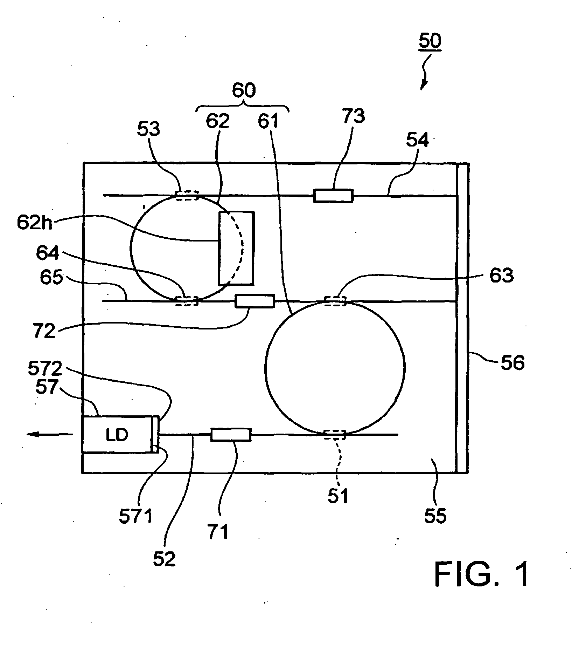

Tunable laser 50 according to a first embodiment of the present invention, shown in FIG. 1, has PLC substrate 55 with multiple ring resonator 60, input/output side waveguide 52, and reflection side waveguide 54 being disposed thereon. Multiple ring resonator 60 comprises two ring resonators 61, 62 having respective ring-shaped waveguides and respective different optical path lengths. Ring resonators 61, 62 are coupled to each other by directional couplers 63, 64 and coupling waveguide 65 thereby constituting multiple ring resonator 50. Input/output side waveguide 52 has an end coupled to ring resonator 61 by directional coupler 51. Reflection side waveguide 54 has an end coupled to ring resonator 62 by directional coupler 53. The other end of reflection side waveguide 54 extends to an end of PLC substrate 55 on which highly reflecting film 56 is disposed as an optical reflector. Light that is propagated through reflection side waveguide 54 to the other end thereof is reflected by highly reflecting film 56 into reflection side waveguide 54, and travels toward the one end thereof that is coupled to ring resonator 62. Highly reflecting film 56 can be formed by, for example, evaporating or applying a dielectric multilayered film to the end face of PLC substrate 55. Mode filters 71, 72, 73 for preventing light in high-order modes from being introduced into multiple ring resonator 60 and propagating only light in a fundamental mode in multiple ring resonator 60 are built respectively in input/output side waveguide 52, coupling waveguide 65, and reflection side waveguide 54.

Ring resonators 61, 62 are fabricated according to the PLC technology. The various waveguides, which include the ring-shaped waveguides of ring resonators 61, 62, input/output side waveguide 52, reflection side waveguide 54, and coupling waveguide 65, comprise quartz glass optical waveguides made of quartz glass deposited on a silicon substrate or a glass substrate. Alternatively, the waveguides may be ferroelectric optical waveguides made of a thin film of ferroelectric material. The ferroelectric material of ferroelectric waveguides may be lithium niobate ($LiNbO_3$), for example.

Film heater 62h for changing the resonant wavelength of multiple ring resonator 60 is disposed over ring resonator 62. Film heater 62h comprises, for example, an aluminum (Al) film deposited on ring resonator 62, and the aluminum film has opposite ends serving as energizing electrodes. Film heater 62h can be deposited by evaporating or applying a metal film to PLC substrate 55, and may be made of platinum (Pt), chromium (Cr), or the like, rather than aluminum.

PLC substrate 55 may be mounted on a Peltier device (not shown) as a temperature adjusting mechanism, so that the overall temperature of PLC substrate 55 can be controlled. The Peltier device keeps the temperature of PLC substrate 55 constant in order to cause the FSR of ring resonator 61 to match the ITU grid.

LD 57, which serves as an optical input/output device, is coupled to the other end of input/output side waveguide 52 through nonreflecting film 572. LD 57 is directly mounted on PLD substrate 55 by the passive alignment technology. The passive alignment technology is a technology for positioning LD 57 using a mark pattern on the surface of PLC substrate 55 and a mark pattern on the chip of LD 57. The passive alignment technology does not require optical axis alignment which has heretofore been carried out in the fabrication of optical modules, and hence is effective in reducing the cost of fabricating optical modules and improving the lead time. Alternatively, LD 57 may be coupled to PLC substrate 55 by a lens, rather than being mounted on PLC substrate 55.

Operation of tunable laser 50 according to the first embodiment will be described below.

Light emitted from LD 57 enters from optical input/output end 571 into input/output side waveguide 52, and travels successively through mode filter 71, directional coupler 51, multiple ring resonator 60, mode filter 72, directional coupler 53, and reflection side waveguide 54, to which mode filter 73 is inserted, to highly reflecting film 56. The light is reflected by highly reflecting film 56, and travels successively through reflection side waveguide 54 and mode filter 73, directional coupler 53, multiple ring resonator 60, directional coupler 51, and input/output side waveguide 52, to which mode filter 71 is inserted, back to optical input/output end 571. The returning light is light in the fundamental mode as mode filters 71, 72, 73 are provided in the optical path. The returning light becomes most intensive at the resonant wavelength of multiple ring resonator 60 because since ring resonators 61, 62 of multiple ring resonator 60 have slightly different FSRs, a greater reflection occurs at a wavelength, i.e., the resonant wavelength, at which periodic changes of reflections (transmissions) occurring in respective ring resonators 61, 62 coincide with each other.

The wavelength at which the periodic changes coincide with each other changes greatly depending on the circumferential lengths of ring resonators 61, 62 and a change in the waveguide refractive index. The waveguide refractive index can be changed according to the thermooptical effect using film heater 62h. Specifically, the resonant wavelength of multiple ring resonator 60 can be changed based on the temperature characteristics of ring resonators 61, 62. With tunable laser 50 according to the present embodiment, as described above, ring resonators 61, 62 whose circumferential lengths or optical path lengths are slightly different from each other are coupled in series to each other, providing multiple ring resonator 60, and the vernier effect provided by multiple ring resonator 60 is utilized to achieve a wide range of variable wavelengths.

In tunable laser 50 according to the present embodiment, the waveguides, multiple ring resonator 60, and highly reflecting film 66 that are disposed on PLC substrate 55 function as a resonator with respect to a laser element, that is, LD 57. If a laser beam generated by tunable laser 50 is to be used in a WDM transmission system, for example, then the laser beam emitted from an end face of LD 57 remote from optical input/output end 571 is introduced into the WDM transmission system, as indicated by the arrow in FIG. 1.

Mode filters 71, 72, 73 used in tunable laser 50 will be described below.

For ring resonators 61, 62 to achieve good wavelength characteristics, it is necessary to prevent light in high-order modes from being propagated in ring resonators 61, 62. Tunable laser 50 shown in FIG. 1 employs mode filters 71, 72, 73 for preventing light in high-order modes from being introduced into multiple ring resonator 60 and propagating only light in a fundamental mode in multiple ring resonator 60. Though it is preferable to have all three mode filters 71, 72, 73 used in tunable laser 50 for the purpose of better wavelength selectivity, only two mode filters may be used in tunable laser 50.

Generally, light in high-order modes is less liable to be confined in the core of an optical waveguide and more liable to leak out of the core of the optical waveguide. If light in high-order modes is propagated in a constricted waveguide, then it is more likely to leak and radiate out of the core and less likely to be propagated in the core. Therefore, constricted waveguides can function as a filter for blocking light in high-order modes. Light in a fundamental mode which is confined in the core of a bent waveguide is propagated therethrough without being radiated out. However, light in high-order modes which bleeds into the cladding is liable to radiate from the bent waveguide. Therefore, a bent waveguide can also be used as a filter for propagating only light in a fundamental mode and blocking light in higher-order modes. Therefore, each of mode filters 71, 72, 73 comprises a constricted waveguide having a narrow local portion or a bent waveguide having a certain radius of curvature.

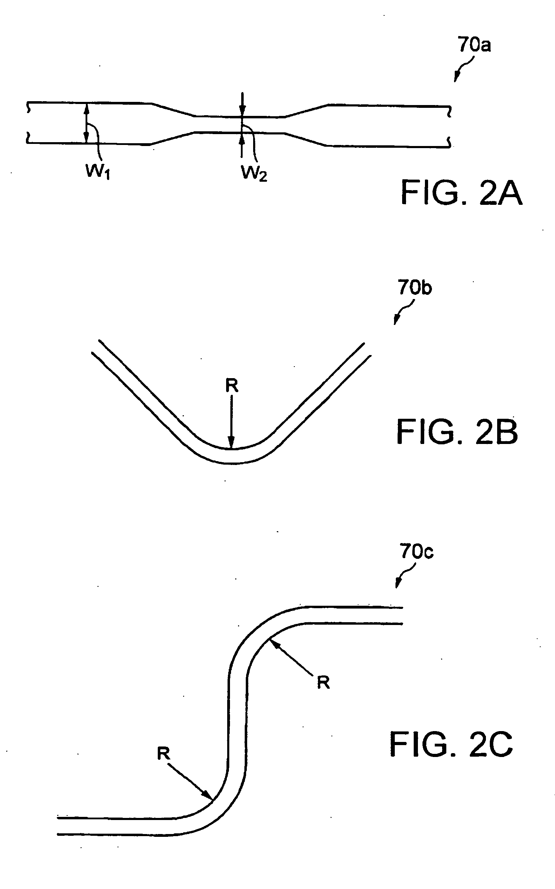

FIGS. 2A, 2B, and 2C show mode filters according to different examples that can be used in the tunable laser according to the present embodiment.

FIG. 2A shows mode filter 70a in the form of a constricted optical waveguide, in accordance with the present invention. The constricted waveguide includes a constricted portion having a width that is in a range of about 10 % to 90 % of the width of an unconstricted portion thereof, allowing mode filter 70a to increase the loss of light in higher-order modes and to propagate light in a fundamental mode efficiently. As shown in FIG. 2A, the width of the constricted portion of the constricted waveguide is represented by $W_2$ and the width of the unconstricted portion of the constricted waveguide is represented by $W_1$. The width $W_2$ should preferably satisfy the following relationship:

$$0.1\,W_1 \leq W_2 \leq 0.9\,W_1$$

If $0.9\,W_1 < W_2$, then the light propagation characteristics of the constricted portion are substantially equal to the light propagation characteristics of the unconstricted portion, and the constricted waveguide will not function effectively as a mode filter for blocking light in higher-order modes. If $W_2 < 0.1\,W_1$, then the constricted waveguide may not be able to propagate even light in a fundamental mode because of the asymmetric distribution of refractive indexes in the waveguide. The above formula defines the upper and lower limits for the width $W_2$.

FIG. 2B shows mode filter 70b in the form of a bent optical waveguide, not in accordance with the present invention. The bent waveguide has a radius R of curvature which is about the same as the radius of curvature of ring resonators 61, 62 for effectively removing light in high-order modes. The radius R of curvature should preferably be smaller than a value that is twice the radius of curvature of ring resonators 61, 62. If the radius R of curvature is greater than the value that is twice the radius of curvature of ring resonators 61, 62, then the bent waveguide will not be significantly different from the other waveguides and will not be able to sufficiently block light in high-order modes.

FIG. 2C shows mode filter 70c in the form of two bent optical waveguides not in accordance with the present invention. Mode filer 70c comprises an S-shaped optical waveguide made up of a combination of two bent waveguides, and operates in the same manner as mode filter 70b.

The tunable laser which incorporates the mode filters described above has better mode selectivity and is capable of oscillating stably in a single axial mode.

As described above, tunable laser 50 according to the first embodiment is of a simple structure free of an external mirror and is capable of changing wavelengths in a wider range than the ordinary DFB-LDs can change wavelengths. Furthermore, since tunable laser 50 has no movable components unlike ordinary external-mirror tunable lasers, tunable laser 50 is highly reliable in operation and is highly resistant to vibrations and shocks. As tunable laser 50 is tuned for wavelengths by controlling the electric power supplied to film heater 62h, any characteristic aging of tunable laser 50 is much smaller than tunable lasers which change wavelengths by injecting an electric current into a semiconductor waveguide. Moreover, the combination of two-component multiple ring resonator 60 and mode filters 71, 72, 73 allows tunable laser 50 to have a good wavelength selection capability, resulting in stable single-axial-mode oscillation characteristics maintained over a long period of time.

Tunable laser 50 according to the first embodiment may have a photodetector and a control circuit as described later.

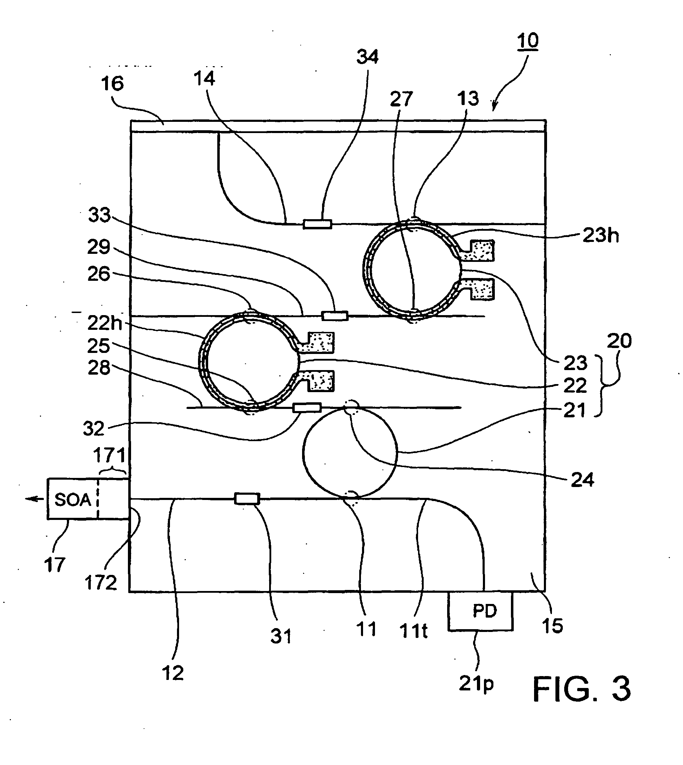

Tunable laser 10 according to a second embodiment of the present invention, shown in FIG. 3, has PLC substrate 15 with multiple ring resonator 20, input/output side waveguide 12, and reflection side waveguide 14 being disposed thereon. Multiple ring resonator 20 comprises three ring resonators 21, 22, 23 that are coupled by directional couplers 24, 25, 26, 27 and coupling waveguide 28, 29. Coupling waveguide 28 is coupled to ring resonators 21, 22 by respective directional couplers 24, 25, and coupling waveguide 29 is coupled to ring resonators 22, 23 by respective directional couplers 26, 27. Mode filters 31, 32, 33, 34 for preventing light in high-order modes from being introduced into multiple ring resonator 20 and propagating only light in a fundamental mode in multiple ring resonator 20 are built respectively in input/output side waveguide 12, coupling waveguide 28, coupling waveguide 29, and reflection side waveguide 14. Each of mode filters 31, 32, 33, 34 has a structure which may be in the form of a constricted waveguide including a constricted portion as shown in FiG.2A or, alternatively to the present invention, a bent waveguide having a certain radius of curvature as shown in FIG. 2B, or 2C. Though it is preferable to have all four mode filters 31, 32, 33, 34 used in tunable laser 10 for the purpose of better wavelength selectivity, only two or three mode filters may be used in tunable laser 10.

Input/output side waveguide 12 has an end coupled to ring resonator 21 by directional coupler 11. Directional coupler 11 has through port 11t connected to photodetector 21p for detecting the resonant wavelength of multiple ring resonator 20. Photodetector 21 p may comprise a photodiode.

SOA (Semiconductor Optical Amplifier) 17 has optical input/output end 172 connected to the other end of input/output side waveguide 12 through a nonreflecting film (not shown), so that SOA 17 is coupled to input/output side waveguide 12. SOA 17 has phase control region 171 held in contact with optical input/output end 172 thereof. SOA 17 controls an electric current flowing through phase control region 171 to control the phase of light applied to or emitted from SOA 17. Since SOA 17 with phase control region 171 is of general nature, its structure and operating principles will not be described in detail below.

Reflection side waveguide 14 has an end coupled to ring resonator 23 by directional coupler 13. The other end of reflective waveguide 14 extends to an end face of PLC substrate 15 on which highly reflecting film 16 is disposed as an optical reflector. Light that is propagated through reflection side waveguide 14 to the other end thereof is reflected by highly reflecting film 16 into reflection side waveguide 14, and travels toward the end thereof that is coupled to ring resonator 23. Highly reflecting film 16 can be formed by evaporating or applying a dielectric multilayer film to the end face of PLC substrate 15.

Ring resonators 21, 22, 23 are fabricated according to the PLC technology, for example. The various waveguides, which include the ring-shaped waveguides of ring resonators 21, 22, 23, input/output side waveguide 12, reflection side waveguide 14, and coupling waveguides 28, 29, comprise quartz glass optical waveguides made of quartz glass deposited on a silicon substrate or a glass substrate. Alternatively, ferroelectric optical waveguides made of a thin film of ferroelectric material, as with the first embodiment.

Film heaters 22h, 23h for changing the resonant wavelength of multiple ring resonator 20 are disposed corresponding to ring resonators 22, 23, respectively. Film heaters 22h, 23h comprise arcuate aluminum films deposited on respective ring resonators 22, 23. Each of the aluminum films has opposite ends serving as energizing electrodes. As with the first embodiment, film heaters 22h, 23h, which may be made of platinum, chromium, or the like, rather than aluminum, can be deposited by evaporating or applying a metal film to PLC substrate 15.

PLC substrate 15 may be mounted on a Peltier device (not shown) as a temperature adjusting mechanism, so that the overall temperature of PLC substrate 15 can be controlled, as with the first embodiment.

Operation principle of tunable laser 10 according to the second embodiment will be described below.

Light emitted from SOA 17 enters from optical input/output end 172 into input/output side waveguide 12, and travels to highly reflecting film 16 successively through mode filter 31, directional coupler 11, multiple ring resonator 20 in which mode filters 32, 33 are inserted, directional coupler 13, and reflection side waveguide 14 in which mode filter 34 is inserted. The light is reflected by highly reflecting film 16, and travels back to optical input/output end 172 and hence SOA 17 successively through reflection side waveguide 14 in which mode filter 34 is disposed, directional coupler 13, multiple ring resonator 20 in which mode filters 32, 33 are disposed, directional coupler 11, input/output side waveguide 12 in which mode filter 31 is disposed. The returning light is light in the fundamental mode as mode filters 31, 32, 33, 34 are provided in the optical path. The returning light becomes most intensive at the resonant wavelength of multiple ring resonator 20 because since ring resonators 21, 22, 23 of multiple ring resonator 20 have slightly different FSRs, a greater reflection occurs at a wavelength, i.e., the resonant wavelength, at which periodic changes of reflections (transmissions) occurring in respective ring resonators 21, 22, 23 coincide with each other. Light that passes through through port 11t of directional coupler 11 becomes minimum at the resonant wavelength of multiple ring resonator 20. Therefore, the resonant wavelength of multiple ring resonator 20 can be detected by detecting the amount of light at through port 11t with photodetector 21 p.

The resonant wavelength, i.e., the wavelength at which the periodic changes coincide with each other changes greatly depending on the circumferential lengths of ring resonators 21, 22, 23 and a change in the waveguide refractive index. The waveguide refractive index can be changed according to the thermooptical effect. Specifically, the resonant wavelength of multiple ring resonator 20 can be changed based on the temperature characteristics of ring resonators 22, 23 by controlling the amount of electric current flowing through film heaters 22h, 23h. At this time, the wavelength of light emitted from SOA 17 is changed by controlling the amount of electric current flowing through phase control region 171. With the tunable laser according to the present embodiment, as described above, ring resonators 21, 22, 23 whose circumferential lengths or optical path lengths are slightly different from each other are coupled in series to each other, providing multiple ring resonator 20, and the vernier effect provided by multiple ring resonator 20 is utilized and the amount of electric current flowing through phase control region 171 is controlled to achieve a wide range of variable wavelengths.

In tunable laser 10 according to the present embodiment, the waveguides, multiple ring resonator 20, and highly reflecting film 16 that are disposed on PLC substrate 15 function as a resonator with respect to a laser element, i.e., SOA 17. If a laser beam generated by tunable laser 10 is to be used in a WDM transmission system, for example, then the laser beam emitted from an end face of SOA 17 remote from optical input/output end 172 is introduced into the WDM transmission system, as indicated by the arrow in FIG. 3.

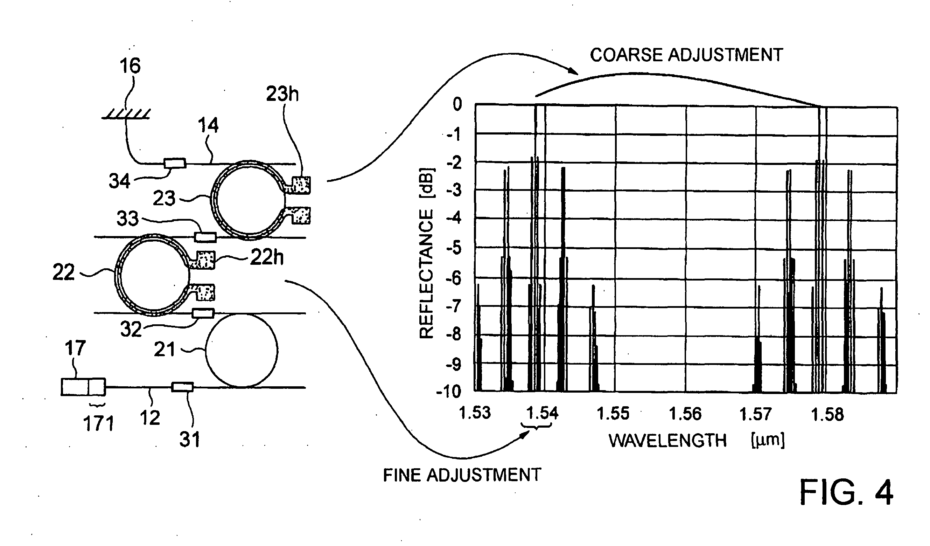

FIG. 4 shows the relationship between wavelength and reflectance observed when ring resonators 21, 22, 23 of tunable laser 10 shown in FIG. 3 had circumferential lengths or optical path lengths of 4000 $\mu$ m, 4400 $\mu$m, and 4040 $\mu$m, respectively. The reflectance is used with respect to light emitted from SOA 17, propagated through multiple ring resonator 20, and returned to SOA 17. Film heater 22h is used for fine adjustment of the wavelength, and film heater 23h is used for coarse adjustment of the wavelength. Furthermore, wavelengths on the order of several tens of picometers (pm) are controlled by changing the amount of electric current flowing through phase control region 171 of SOA 17.

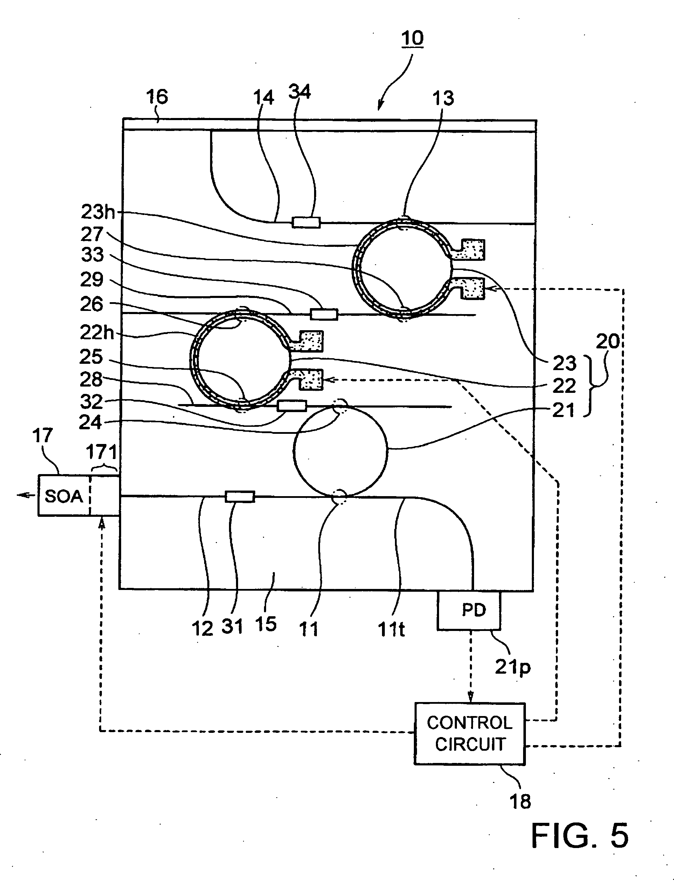

FIG. 5 shows in plan a modified tunable laser which comprises tunable laser 10 shown in FIG. 3 and a control circuit added thereto. Those parts of the tunable laser shown in FIG. 5 which are identical to those of tunable laser 10 shown in FIG. 3 are denoted by identical reference characters, and will not be described in detail below.

Control circuit 18 that is added to tunable laser 10 mainly comprises a processor such as a DSP (Digital Signal Processor) or an MPU (Micro processing Unit), and a memory for storing a program to be executed by the processor. Control circuit 18 controls the amounts of electric current flowing through film heaters 22h, 23h and phase control region 171 in order to minimize the amount of light detected by photodetector 21p, i.e., to maintain the resonant wavelength at a constant value. For example, control circuit 18 controls the amounts of electric current flowing through film heaters 22h, 23h and phase control region 171, thereby changing the wavelength in a sinusoidal fashion, and searches for a wavelength at which the amplitude of a photoelectric current generated by photodetector 21 p becomes minimum. The wavelength thus searched for is the wavelength to be determined.

Tunable laser 10 according to the second embodiment will generally be described below with reference to FIGS. 3 to 5.

Tunable laser 10 is of such a structure as to select a resonant mode for oscillation in a single axial mode, using the wavelength transmittance characteristics of the drop ports of ring resonators 21, 22, 23. Three ring resonators 21, 22, 23 of multiple ring resonator 20 have slightly different circumferential lengths. Since the resonant peak wavelengths of three ring resonators 21, 22, 23 coincide with each other only once in a wide wavelength range of several tens of nanometers (nm), and also since the mode selectivity is increased by the insertion of mode filters 31, 32, 33, 34, tunable laser 10 is capable of oscillating stably in a single axial mode.

The wavelength is changed mainly by changing the amounts of electric current flowing through film heaters 22h, 23h on ring resonators 22, 23. Output light from through port 11t of ring resonator 21 that is free of a film heater is extracted and converted by photodetector 21 p into an electric current to detect a wavelength error. Output light can be extracted from not only the drop ports of ring resonators 21, 22, 23, but also the through ports thereof which have a wavelength blocking capability. According to the present embodiment, wavelengths are detected using output light from the through ports.

The tunable laser according to the present embodiment resides mainly in that it has photodetector 21 p for detecting light from through port 11t and the FSR of ring resonator 21 for dividing detected light matches the ITU grid. The latter feature allows the oscillating wavelength to be obtained as a discrete wavelength matching the ITU grid according to single-axial-mode oscillation. At this time, the wavelength selectivity of mode filters 31, 32, 33, 34 acts effectively. However, a problem arises in that a deviation from the ITU grid is unknown. According to the present embodiment, this problem is solved by controlling the phase of ring resonators 22, 23 which operate to change the wavelengths, or the phase of SOA 17 in order to minimize the output light from through port 11t of ring resonator 21. Specifically, wavelength control is performed precisely by slightly changing the wavelength and selecting a wavelength to minimize the amplitude of a detected signal that is produced as a result.

The present invention is not limited to the above embodiments. The multiple ring resonator is not limited to comprising two or three ring resonators, but may have four or more ring resonators that are interconnected. The ring resonators may be directly connected only by directional couplers. The LD or SOA and the multiple ring resonator may be monolithically integrated on one substrate.

While preferred embodiments of the present invention have been described using specific terms, such description is for illustrative purposes only, and it is to be understood that changes and variations may be made without departing from the scope of the following claims.

**Claims**

1.    A tunable laser comprising:

a multiple ring resonator (20,60) comprising a plurality of ring resonators (21, 22, 23, 61, 62) coupled in series to each other, having respective ring-shaped waveguides and respective different optical path lengths;
a first optical waveguide (12, 52) coupled to said multiple ring resonator (20, 60);
an optical amplifier (17, 57) coupled to said first optical waveguide (12, 52);
a second optical waveguide (14, 54) coupled to said multiple ring resonator (20, 60);
an optical reflector (16, 56) coupled to said second optical waveguide (14, 54); and
a wavelength varying mechanism (22h, 23h, 62h), for changing the resonant wavelength of said multiple ring resonator (20, 60);**characterised in that** said first and second optical waveguides (12, 14, 52, 54) comprise a mode filter (31,34,71,73) for preventing light in high-order modes from being introduced into said multiple ring resonator (20,60) and for propagating light in a fundamental mode in said multiple ring resonator (20,60), wherein said mode filter (31,34,71,73) comprises a constricted waveguide having a width for propagating light in said fundamental mode therethrough

2.    The tunable laser according to claim 1, further comprising a substrate (15,55), wherein said multiple ring resonator (20,60), said first optical waveguide (12,52), and said second optical waveguide (14,54) are disposed on said substrate (15,55).

3.    The tunable laser according to claim 2, wherein said mode filter (31,34,71,73) is disposed on said substrate (15,55).

4.    The tunable laser according to claim 1,2 or 3, wherein said multiple ring resonator (20,60) has an optical coupler (24,25,26,27,63,64) coupling said plurality of ring resonators (21,22,23,61,62).

5.    The tunable laser according to claim 4, wherein said optical coupler ( 24,25,26,27,63,64) has a coupling waveguide (28,29,65), said mode filter (31,34,71,73) is disposed on said substrate (15,55), and said mode filter (31,34,71,73) is inserted in at least one of said coupling waveguide (28,29,65), said first optical waveguide (12,52) and said second optical waveguide (14,54).

6.    The tunable laser according to claim 3,4 or 5, wherein said mode filter (31,34,71,73) comprises a bent waveguide having a radius of curvature for propagating light in said fundamental mode therethrough.

**Patentansprüche**

1.    Abstimmbarer Laser, mit:

einem Mehrfachringresonator (20, 60) mit mehreren in Serie geschalteten Ringresonatoren (21, 22, 23, 61, 62) mit jeweils ringförmigen Wellenleitern und jeweils verschiedenen optischen Weglängen;
einem mit dem Mehrfachringresonator (20, 60) gekoppelten ersten optischen Wellenleiter (12, 52);
einem mit dem ersten optischen Wellenleiter (12, 52) gekoppelten optischen Verstärker (17, 57);
einem mit dem Mehrfachringresonator (20, 60) gekoppelten zweiten optischen Wellenleiter (14, 54);
einem mit dem zweiten optischen Wellenleiter (14, 54) gekoppelten optischen Reflektor (16, 56); und
einem Wellenlängenänderungsmechanismus (22h, 23h, 62h) zum Ändern der Resonanzwellenlänge des Mehrfachringresonators (20, 60);

**dadurch gekennzeichnet, dass**
der erste und der zweite optische Wellenleiter (12, 14, 52, 54) ein Modenfilter (31, 34, 71, 73) aufweisen zum Verhindern, dass Licht mit Moden höherer Ordnung in den Mehrfachringresonator (20, 60) eingekoppelt wird, und zum Ausbreiten von Licht in einem Grundmodus im Mehrfachringresonator (20, 60); wobei der Modenfilter (31, 34, 71, 73) einen eingeschnürten Wellenleiter mit einer Breite zum Durchlaß von Licht im Grundmodus durch den Wellenleiter aufweist.

2. Abstimmbarer Laser nach Anspruch 1, ferner mit einem Substrat (15, 55), wobei der Mehrfachringresonator (20, 60), der erste optische Wellenleiter (12, 52) und der zweite optische Wellenleiter (14, 54) auf dem Substrat (15, 55) angeordnet sind.

3. Abstimmbarer Laser nach Anspruch 2, wobei der Modenfilter (31, 34, 71, 73) auf dem Substrat (15, 55) angeordnet ist.

4. Abstimmbarer Laser nach Anspruch 1, 2 oder 3, wobei der Mehrfachringresonator (20, 60) einen optischen Koppler (24, 25, 26, 27, 63, 64) zum Koppeln der mehreren Ringresonatoren (21, 22, 23, 61, 62) aufweist.

5. Abstimmbarer Laser nach Anspruch 4, wobei der optische Koppler (24, 25, 26, 27, 63, 64) einen Kopplungswellenleiter (28, 29, 65) aufweist, der Modenfilter (31, 34, 71, 73) auf dem Substrat (15, 55) angeordnet ist und der Modenfilter (31, 34, 71, 73) in den Kopplungswellenleiter (28, 29, 65) und/oder den ersten optischen Wellenleiter (12, 52) und/oder den zweiten optischen Wellenleiter (14, 54) eingefügt ist.

6. Abstimmbarer Laser nach Anspruch 3, 4 oder 5, wobei der Modenfilter (31, 34, 71, 73) einen gebogenen Wellenleiter mit einem Krümmungsradius zum Durchlaß von Licht im Grundmodus durch den Wellenleiter aufweist.

## Revendications

1. Laser accordable comprenant :

un résonateur annulaire multiple (20, 60) comprenant une pluralité de résonateurs annulaires. (21, 22, 23, 61, 62) couplés en série les uns aux autres, ayant des guides d'ondes en forme d'anneaux respectifs et différentes longueurs de trajet optique respectives ;
un premier guide d'ondes optique (12, 52) couplé audit résonateur annulaire multiple (20, 60) ;
un amplificateur optique (17, 57) couplé audit premier guide d'ondes optique (12, 52) ;
un second guide d'ondes optique (14, 54) couplé audit résonateur annulaire multiple (20, 60) ;
un réflecteur optique (16, 56) couplé audit second guide d'ondes optique (14, 54) ; et
un mécanisme de modification de longueur d'onde (22h, 23h, 62h) pour modifier la longueur d'onde de résonance dudit résonateur annulaire multiple (20, 60) ;

**caractérisé en ce que** lesdits premier et second guides d'ondes optiques (12, 14, 52, 54) comprennent un filtre de mode (31, 34, 71, 73) pour empêcher l'introduction de lumière dans des modes d'ordres élevés dans ledit résonateur annulaire multiple (20, 60) et pour propager la lumière dans un mode fondamental dans ledit résonateur annulaire multiple (20, 60), dans lequel ledit filtre de mode (31, 34, 71, 73) comprend un guide d'ondes à resserement, ayant une largeur pour propager la lumière dans ledit mode fondamental à travers celui-ci.

2. Laser accordable selon la revendication 1, comprenant en outre un substrat (15, 55), dans lequel ledit résonateur annulaire multiple (20, 60), ledit premier guide d'ondes optique (12, 52) et ledit second guide d'ondes optique (14, 54) sont disposés sur ledit substrat (15, 55).

3. Laser accordable selon la revendication 2, dans lequel ledit filtre de mode (31, 34, 71, 73) est disposé sur ledit substrat (15, 55).

4. Laser accordable selon la revendication 1, 2 ou 3, dans lequel ledit résonateur annulaire multiple (20, 60) comporte un coupleur optique (24, 25, 26, 27, 63, 64) couplant ladite pluralité de résonateurs annulaires (21, 22, 23, 61, 62).

5. Laser accordable selon la revendication 4, dans lequel ledit coupleur optique (24, 25, 26, 27, 63, 64) comporte un guide d'ondes de couplage (28, 29, 65), ledit filtre de mode (31, 34, 71, 73) est disposé sur ledit substrat (15, 55), et ledit filtre de mode (31, 34, 71, 73) est inséré dans au moins l'un dudit guide d'ondes de couplage (28, 29, 65), dudit premier guide d'ondes optique (12, 52) et dudit second guide d'ondes optique (14, 54).

6. Laser accordable selon la revendication 3, 4 ou 5, dans lequel ledit filtre de mode (31, 34, 71, 73) comprend un guide d'ondes coudé ayant un rayon de courbure pour propager la lumière dans ledit mode fondamental à travers celui-ci.

FIG. 1

70a

$W_1$    $W_2$

# FIG. 2A

70b

R

# FIG. 2B

70c

R

R

# FIG. 2C

FIG. 3

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2004034528 A

**Non-patent literature cited in the description**

• **TAKAHASHI M et al.** A stable widely tunable laser using a silica-waveguide triple-ring resonator. *OPTICAL FIBER COMMUNICATIONS CONFERENCE,* 06 March 2005, vol. 5

• **BENTE E A J M et al.** WAVELENGTH SELECTION IN AN INTEGRATED MULTIWAVELENGTH RING LASER. *IEEE JOURNAL OF QUANTUM ELECTRONICS,* September 2004, vol. 40 (9), 1208-1216